# EUROPÄISCHE PATENTSCHRIFT

(11) **EP 0 931 335 B1**
(45) Veröffentlichungstag und Bekanntmachung des Hinweises auf die Patenterteilung: **26.03.2003**
(21) Anmeldenummer: 97944687.9
(22) Anmeldetag: 09.09.1997
(51) Int. Cl.: H01L 21/3205, H01G 4/00

(54) **MEHRSCHICHTELEKTRODEN BESTEHEND AUS Pt UND EINEM UNEDLEN METALL FÜR SPEICHERKONDENSATOREN**
MULTI LAYERED ELECTRODES COMPOSED OF Pt AND A BASE METAL FOR STORAGE CAPACITORS
ELECTRODES MULTICOUCHES CONSTITUEES DE Pt ET D'UN METAL COMMUN POUR CONDENSATEURS DE MEMORISATION

(30) Priorität: 30.09.1996 DE 19640218
(43) Veröffentlichungstag der Anmeldung: 28.07.1999
(73) Patentinhaber: Infineon Technologies AG, 81669 München (DE)
(72) Erfinder: SCHINDLER, Günther, D-80802 München (DE); HARTNER, Walter, D-89441 Medlingen (DE); HINTERMAIER, Frank, D-81373 München (DE); MAZURE-ESPEJO, Carlos, D-85604 Zorneding (DE); BRUCHHAUS, Rainer, D-80997 München (DE); HÖNLEIN, Wolfgang, D-82008 Unterhaching (DE); ENGELHARDT, Manfred, D-83620 Feldkirchen-Westerham (DE)
(74) Vertreter: Zimmermann & Partner
(86) Internationale Anmeldenummer: DE9702005
(87) Internationale Veröffentlichungsnummer: WO98014990

(56) Entgegenhaltungen:
- EP-A- 0 489 519
- EP-A- 0 514 149
- EP-A- 0 698 918
- US-A- 5 581 436

## Beschreibung

Die Erfindung betrifft eine integrierte Halbleiterspeicheranordnung gemäß den Merkmalen des Oberbegriffs des Anspruchs 1.

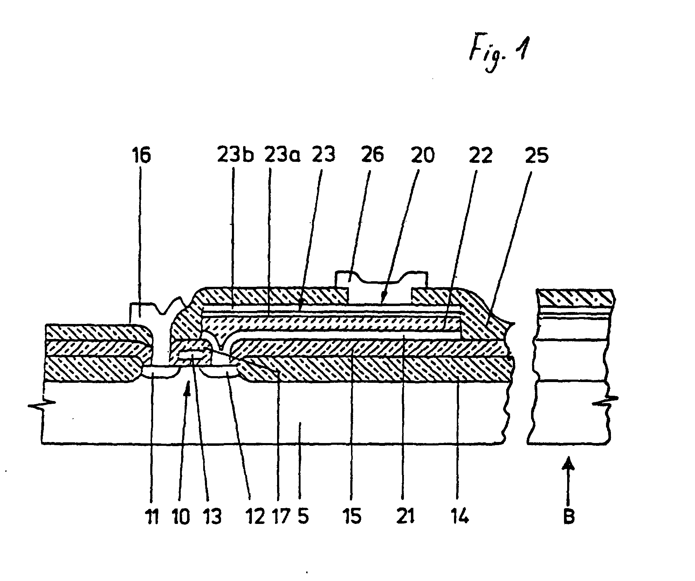

Solche integrierte Halbleiterspeicheranordnungen sind z.B. in EP 0 514 149 A1 beschrieben. Dort werden die eine Dielektrikumsschicht oben und unten begrenzenden oberen und unteren Elektroden mehrschichtig gestaltet. Die jeweils dem Substrat näher zugewandte Schicht weist einen hohen Schmelzpunkt auf und reagiert nicht mit der Dielektrikumsschicht. Als Beispiele für die dem Substrat jeweils näher zugewandte Schicht sind Titan, Tantal, Wolfram, Molybdän und dgl. genannt. Für die darüber angeordnete Schicht sind Platin, Palladium, Rhodium und Aluminium genannt. Die auf der Dielektrikumsschicht sitzende obere Elektrode weist, wie ein Beispiel in EP 0 514 149 A1 zeigt (vgl. dortige Fig. 1), folglich eine untere Schicht aus Titan und eine darüber sitzende Schicht aus Platin auf. Die Titan-Schicht soll eine Dicke zwischen 10 bis 150 nm und die Platin-Schicht eine Dicke zwischen 100 und 1200 nm aufweisen.

Mittlerweile werden für den Speicherkondensator oxidkeramische Dielektrika eingesetzt, da mit diesen Dielektrika verhältnismäßig große Kapazitäten bei geringem Platzbedarf realisierbar sind. Als oxidkeramische Dielektrika werden Hoch-ε -Materialien, wie z. B. (BaₓSr₁₋ₓTiO₃) oder das ferroelektrische Material SrBi₂Ta₂O₉ eingesetzt. Aufgrund des hohen Sauerstoffanteils im Dielektrikum und der bei der Abscheidung oder beim Tempern nötigen Sauerstoffatmosphäre sind bisher verwandte Elektrodenmaterialien, wie Aluminium, Polysilizium oder Silizide nicht mehr einsetzbar.

Als neues Elektrodenmaterial wird deshalb mittlerweile Platin eingesetzt, wie die US 5,330,931 oder US 5,466,629 zeigen.

Die Strukturierung von Platin ist bisher noch nicht zufriedenstellend gelöst. Der Ätzvorgang wird vorrangig über physikalische Prozesse durch Ionen hoher Energie durchgeführt. Darüber hinaus ist es mittlerweile bekannt, Platin anisotrop zu ätzen. Allerdings sind bei diesem anisotropen Ätzen die erreichbaren Ätzprofile immer noch nicht zufriedenstellend. Außerdem weist Platin einen höheren elektrischen Widerstand als z. B. Aluminium auf, nämlich ca. 10 µOhm*cm. Diese Nachteile machen Platin bisher unattraktiv als Elektrodenmaterial, obwohl es hervorragende Eigenschaften bezüglich des Übergangs zu den Ferroelektrika und Hoch-Dielektrika aufweist.

Die Erfindung hat deshalb das Ziel, eine integrierte Halbleiterspeicheranordnung anzugeben, die im Hinblick auf die bisher bekannten Halbleiterspeicheranordnungen mit reinen Platin-Elektroden verbessert ist und sich insbesondere leicht herstellen läßt.

Dieses Ziel wird mit einer integrierten Halbleiterspeicheranordnung gemäß den Merkmalen des Patentanspruchs 1 gelöst.

Demnach ist zumindest die obere der Elektroden des Speicherkondensators schichtartig aufgebaut mit einer der Dielektrikumsschicht zugewandten Platin-Schicht und einer auf der Platin-Schicht sitzenden unedlen Metallschicht, welche im Vergleich zur Platin-Schicht eine größere Dicke aufweist. Als unedle Metallschicht kann beispielsweise eine AluminiumSchicht oder eine Wolfram-Schicht eingesetzt werden.

Die Platin-Schicht weist eine Dicke von wenigen nm auf, beispielsweise bis zu 10 nm. Die darüberliegende unedle Metallschicht ist dagegen dicker ausgebildet und verfügt über eine Dicke von bis zum mehreren 100 nm, z.B. bis zu 800 nm.

Die integrierte Halbleiterspeicheranordnung nach der Erfindung mit einer sandwichartig aufgebauten Elektrode weist gegenüber Elektroden aus reinem Platin bzw. einem anderen Edelmetall folgende Vorteile auf:
- Wird die schichtartige Elektrodenstruktur bei beiden Elektroden des Speicherkondensators verwendet, bleibt durch die dünne Platin-Schicht die Symmetrie der Elektrodenkonfiguration erhalten. Damit lassen sich nachteilige Effekte, wie z.B. Imprint oder Verschiebung der Hystereseschleife, vermeiden.
- Für das unedle Metall kann eine bekannte Standardtechnologie verwendet werden, um dieses Metall auf die dünne Platin-Schicht aufzubringen. Als Standardtechnologie ist beispielsweise die CVD-Abscheidung von Aluminium oder Wolfram geeignet.
- Der spezifische Widerstand der erfindungsgemäßen Elektrodenstruktur ist gegenüber Elektroden aus reinem Platin geringer. Damit läßt sich die erfindungsgemäße obere Elektrode nicht nur für einen einzelnen Speicherkondensator sondern ein ganzes Speicherzellenfeld mit einer Vielzahl von einzelnen Speicherkondensatoren und auch als Verdrahtung in anderen Bereichen der integrierten Halbleiterspeicheranordnung verwenden. Dabei kommt der Vorteil des geringeren elektrischen Widerstandes der oberen Elektrode zum Tragen.
- Eine sehr dünne Platin-Schicht stellt keine so hohen Ansprüche an den Ätzprozeß im Hinblick auf Kantensteilheit, Ätzgeschwindigkeit usw.. Damit vereinfacht sich der Ätzprozeß für Platin. Das auf die Platin-Schicht aufgebrachte andere Metall kann mit einem Standardprozeß geätzt werden und als Hartmask für die Platin-Ätzung verwendet werden.
- Bei der Verwendung von dreidimensionalen Strukturen mit nicht zu großem Aspektverhältnis kann für Platin ein Sputterprozeß verwendet werden, solange dieser Prozeß zumindest eine geringe Kantenbedeckung liefert. Das auf die Platin-Schicht aufgebrachte unedle Metall kann mit CVD (chemicalvapour-deposition) abgeschieden werden, so daß der geringere Dickenunterschied bei der Platin-Schicht nicht ins Gewicht fällt. Die Entwicklung eines CVD-Prozesses für Platin ist erfindungsgemäß daher nicht mehr zwingend.

Die Erfindung wird nachfolgend im Zusammenhang mit einer Figur anhand eines Ausführungsbeispieles näher erläutert.

In der dargestellten Figur ist ein beispielsweise aus Siliziummaterial bestehender Halbleiterkörper 5 dargestellt. Unterhalb der oberen Hauptfläche dieses Halbleiterkörpers 5 ist in an sich bekannter Weise ein Auswahltransistor 10 integriert. Dieser Auswahltransistor 10 verfügt über ein Drain Gebiet 11 und ein benachbart angeordnetes Source-Gebiet 12. Das Drain-Gebiet 11 und das Source-Gebiet 12 sind beispielsweise n⁺dotierte, wannenförmige Gebiete, die zueinander beabstandet in einem p-Substrat des Halbleiterkörpers 5 integriert sind. Darüber hinaus weist der Auswahltransistor 10 in an sich bekannter Weise ein Gate-Gebiet 13 auf, das von einer Isolationsschicht 17 umgeben ist. Das Gate-Gebiet 13 befindet sich, wie bei Auswahltransistoren in Speicherzellen üblich, oberhalb des Zwischenraumes zwischen dem Drain-Gebiet 11 und dem Source-Gebiet 12. Das Gate-Gebiet 13 steht beispielsweise mit einer Bit-Leitung der Speicheranordnung in elektrisch leitender Verbindung. Das Drain-Gebiet 11 ist mit einem Kontakt 16 beispielsweise mit der Wort-Leitung der Speicheranordnung elektrisch in Kontakt.

Das Source-Gebiet 12 ist mit einer ersten Elektrode 21 in elektrisch leitender Verbindung. Diese Elektrode 21 erstreckt sich im dargestellten Ausführungsbeispiel der Schnittansicht des Halbleiterkörpers 5 ausgehend von dem Source-Gebiet 12 etwas nach oben, um dann L-förmig nach rechts in etwa parallel zur oberen Hauptfläche des Halbleiterkörpers 5 weiterzulaufen. Über dieser ersten Elektrode 21 ist eine Dielektrikumsschicht 22 und über dieser Dielektrikumschicht 22 eine zweite Elektrode 23 angeordnet. Die beiden Elektroden 21, 23 und die Dielektrikumsschicht 22 bilden den Speicherkondensator 20 einer Speicherzelle der erfindungsgemäßen Halbleiterspeicheranordnung. Die in der Figur dargestellte obere Elektrode 23 des Speicherkondensators 20 ist mit einem Kontakt 26 elektrisch leitend verbunden. Dieser Kontakt 26 ist beispielsweise an Bezugspotential der Halbleiteranordnung gelegt.

Die gesamte Halbleiterspeicheranordnung besteht aus einer Vielzahl von Speicherzellen, wie diese in der Figur dargestellt ist. Um die einzelnen Speicherzellen voneinander elektrisch zu trennen ist der Auswahltransistor 10 mit seinem Drain-Gebiet 11, Source-Gebiet 12 und Gate-Gebiet 13 rahmenförmig von einer p⁺-Schicht 14 umgeben. Über dieser p⁺-Schicht 14 ist eine Isolationsschicht 15 aufgebracht, die sich zwischen die unteren Elektrode 21 und die p⁺-Schicht 14 hineinerstreckt. Die mit dem Bezugszeichen 25 bezeichnete Schicht ist eine Passivierungsschicht, welche vor dem Metallisierungsschritt für die Kontakte 16 und 26 auf den Halbleiterkörper 5 aufgebracht wird.

Wie die Schnittansicht des dargestellten Ausführungsbeispieles zeigt, ist die obere Elektrode 23 des Speicherkondensators 20 schichtartig aufgebaut. Die Elektrode 23 besteht aus einer verhältnismäßig dünnen Platin-Schicht 23a, die direkt auf der Dielektrikumsschicht 22 sitzt. Die Platin-Schicht 23a kann beispielsweise eine Dicke von bis zu etwa 10 nm aufweisen. Über dieser Platin-Schicht 23a und damit abgewandt zur Dielektrikumsschicht 22 sitzt eine weitere Metallschicht 23b. Diese weitere Metallschicht 23b kann aus einem Standardmaterial bestehen, wie es bisher bei Elektroden für Speicherkondensatoren in integrierten Halbleiterspeicheranordnungen eingesetzt wurde. Die Metallschicht 23b kann beispielsweise aus einem unedlen Metall, vorzugsweise Aluminium oder Wolfram, bestehen. Diese weitere Metallschicht 23b weist eine größere Dicke als die Platin-Schicht 23a auf. Die Metallschicht 23b ist größer 10 nm und vorzugsweise kleiner etwa 800 nm dick.

Die zweite Metallschicht 23b kann durch ein Standardverfahren, z. B. CVD-Abscheidung, auf die Platin-Schicht 23a aufgebracht werden. Die Platin-Schicht 23a wird beispielsweise durch einen Sputterprozeß auf die Dielektrikumsschicht 22 aufgebracht.

Es ist darüber hinaus grundsätzlich auch möglich, die erste Elektrode 21 in ähnlicher Weise wie die zweite Elektrode 23 aufzubauen. In diesem Fall würde die Elektrode 21 ebenfalls schichtartig aufgebaut sein, wobei die dünne Platin-Schicht dann der Dielektrikumsschicht 22 zugewandt sein muß. Aus Symmetriegründen sollte die zweite Metallschicht der ersten Elektrode 21 aus dem gleichen Material bestehen, wie die zweite Metallschicht 23b der zweiten Elektrode 23.

Als Dielektrika können Ferroelektrika oder Hoch-ε-Dielektrika eingesetzt werden.

Wie in Fig. 1 zusätzlich gezeigt, kann die schichtartig aufgebaute obere Elektrode 23 mit der Platin-Schicht 23a und darüber sitzender unedler Metallschicht 23b als Verdrahtung in übrigen Bereichen der Halbleiterspeicheranordnung verwendet ist.. Hierzu setzt sich die Schichtstruktur mit der Platin-Schicht 23a und darüber sitzender unedler Metallschicht 23b in einen übrigen -lediglich schematisch angedeuteten - Bereich B des Halbleiterkörpers 5 fort. Der spezifische Widerstand der erfindungsgemäßen Elektrodenstruktur ist gegenüber Elektroden aus reinem Platin geringer, so daß die Schichtstruktur ohne weiteres im übrigen Halbleiterkörper 5 als Verdrahtung einsetzbar ist.

### Bezugszeichenliste

- 5: Halbleiter
- 10: Auswahltransistor
- 11: Drain-Gebiet
- 12: Source-Gebiet
- 13: Gate-Gebiet
- 14: p⁺-Schicht
- 15: Isolationsschicht
- 16: Kontakt
- 20: Speicherkondensator
- 21: Elektrode
- 22: Dielektrikumsschicht
- 23: Elektrode
- 25: Passivierungsschicht
- 26: Kontakt

- 23a: Platin-Schicht
- 23b: Metallschicht

- B: Bereich

## Patentansprüche

1. Integrierte Halbleiterspeicheranordnung mit einem Halbleiterkörper, in welchem Auswahltransistoren (10) integriert sind, sowie mit Speicherkondensatoren (20), die jeweils eine Dielektrikumsschicht (22) aufweisen, welche zwischen einer unteren und einer oberen Elektrode (21, 23) angeordnet ist, wobei die obere Elektrode (23) schichtartig aufgebaut ist und eine auf der Dielektrikumsschicht (22) sitzende Platin-Schicht (23a) mit darüberliegender unedlen Metallschicht (23b) aufweist, **dadurch gekennzeichnet, dass** die Platin-Schicht (23a) eine Dicke von bis zu 10nm aufweist, und dass die unedle Metallschicht (23b) eine größere Dicke als die platin-Schicht (23) hat.

2. Integrierte Halbleiterspeicheranordnung nach Anspruch 1, **dadurch gekennzeichnet, daß** die schichtartig-aufgebaute obere Elektrode (23) mit der Platin-Schicht (23a) und darüber sitzender unedler Metallschicht (23b) als Verdrahtung in übrigen Bereichen der Halbleiterspeicheranordnung verwendet ist.

3. Integrierte Halbleiterspeicheranordnung nach einem der Ansprüche 1 bis 3, **dadurch gekennzeichnet, daß** die unedle Metallschicht (23b) eine Dicke von größer 10 nm bis 800 nm aufweist.

4. Integrierte Halbleiterspeicheranordnung nach eine der Ansprüche 1 bis 3, **dadurch gekennzeichnet, daß** die unedle Metallschicht eine Aluminium- oder Wolfram-Schicht ist.

5. Integrierte Halbleiterspeicheranordnung nach einem der Ansprüche 1 bis 4, **dadurch gekennzeichnet, daß** auch die untere Elektrode (21, 23) schichtartig aufgebaut ist, und der Dielektrikumsschicht (23) zugewandt eine im Vergleich zur unedlen Metallschicht (23b) dünnere Platin-Schicht (23a) aufweist.

6. Integrierte Halbleiterspeicheranordnung nach einem der Ansprüche 1 bis 5, **dadurch gekennzeichnet, daß** sowohl die Elektroden (21, 23) als auch die Dielektrikumsschicht (22) weitgehend parallel zur oberen Hauptfläche des Halbleiterkörpers 5 angeordnet sind.

7. Integrierte Halbleiterspeicheranordnung nach einem der Ansprüche 1 bis 6, **dadurch gekennzeichnet, daß** die Dielektrikumsschicht (22) ein Ferroelektrikum oder ein Hoch-ε-Dielektrikum ist.

8. Integrierte Halbleiterspeicheranordnung nach einem der Ansprüche 1 bis 7, **dadurch gekennzeichnet, daß** die Platin-Schicht (23a) durch einen Sputterprozeß auf den Halbleiterkörper aufgebracht ist.

9. Integrierte Halbleiterspeicheranordnung nach einem der Ansprüche 1 bis 8, **dadurch gekennzeichnet, daß** die unedle Metallschicht (23b) durch einen CVD-Prozeß auf den Halbleiterkörper abgeschieden ist.

## Claims

1. Integrated semiconductor memory arrangement having a semiconductor body in which selection transistors (10) are integrated, and also having storage capacitors (20) each having a dielectric layer (22) arranged between a lower and an upper electrode (21, 23), the upper electrode (23) being constructed in a layered manner and having a platinum layer (23a) with a base metal layer (23b) lying above it, said platinum layer being seated on the dielectric layer (22), **characterized in that** the platinum layer (23a) has a thickness of up to 10 nm, and **in that** the base metal layer (23b) has a larger thickness than the platinum layer (23a).

2. Integrated semiconductor memory arrangement according to Claim 1, **characterized in that** the upper electrode (23) constructed in a layered manner, having the platinum layer (23a) and the base metal layer (23b) seated above the latter, is used as interconnection in remaining regions of the semiconductor memory arrangement.

3. Integrated semiconductor memory arrangement according to one of Claims 1 to 2, **characterized in that** the base metal layer (23b) has a thickness of greater than 10 nm to 800 nm.

4. Integrated semiconductor memory arrangement according to one of Claims 1 to 3, **characterized in that** the base metal layer is an aluminium or tungsten layer.

5. Integrated semiconductor memory arrangement according to one of Claims 1 to 4, **characterized in that** the lower electrode (21, 23) is also constructed in a layered manner, and, facing the dielectric layer (22), has a platinum layer (23a) which is thinner than the base metal layer (23b).

6. Integrated semiconductor memory arrangement according to one of Claims 1 to 5, **characterized in that** both the electrodes (21, 23) and the dielectric layer (22) are arranged largely parallel to the upper main area of the semiconductor body 5.

7. Integrated semiconductor memory arrangement according to one of Claims 1 to 6, **characterized in that** the dielectric layer (22) is a ferroelectric or a high-ε dielectric.

8. Integrated semiconductor memory arrangement according to one of Claims 1 to 7, **characterized in that** the platinum layer (23a) is applied to the semiconductor body by means of a sputtering process.

9. Integrated semiconductor memory arrangement according to one of Claims 1 to 8, **characterized in that** the base metal layer (23b) is deposited onto the semiconductor body by means of a CVD process.

## Revendications

1. Dispositif de mémoire intégrée à semiconducteur comprenant un corps semiconducteur, dans lequel sont intégrés des transistors (10) de sélection, ainsi que des condensateurs (20) de mémoire, ayant respectivement une couche (22) diélectrique qui est interposée entre une électrode (21) inférieure et une électrode (23) supérieure, l'électrode (23) supérieure étant stratifiée et ayant une couche (23a) en platine reposant sur la couche (22) diélectrique avec au-dessus une couche (23b) en métal non précieux, **caractérisé en ce que** la couche (23a) en platine a une épaisseur allant jusqu'à 10 nm et **en ce que** la couche (23b) en métal non précieux a une épaisseur plus grande que la couche (23) en platine.

2. Dispositif de mémoire intégrée à semiconducteur suivant la revendication 1, **caractérisé en ce que** l'électrode (23) supérieure stratifiée ayant la couche (23a) en platine et au-dessus la couche (23b) en métal non précieux est utilisée comme câblage dans les autres parties du dispositif de mémoire à semiconducteur.

3. Dispositif de mémoire intégrée à semiconducteur suivant l'une des revendications 1 à 3, **caractérisé en ce que** la couche (23b) en métal non précieux a une épaisseur de plus de 10 nm à 800 nm.

4. Dispositif de mémoire intégrée à semiconducteur suivant l'une des revendications 1 à 3, **caractérisé en ce que** la couche en métal non précieux est une couche d'aluminium ou une couche de tungstène.

5. Dispositif de mémoire intégrée à semiconducteur suivant l'une des revendications 1 à 4, **caractérisé en ce que** l'électrode (21, 23) inférieure est aussi stratifiée et comprend une couche (23a) en platine plus mince que la couche (23b) en métal non précieux et tournée vers la couche (23) directrice.

6. Dispositif de mémoire intégrée à semiconducteur suivant l'une des revendications 1 à 5, **caractérisé en ce que** tant les électrodes (21, 23) que la couche (22) diélectrique sont dans une grande mesure disposées parallèlement à la surface principale supérieure du corps (5) semiconducteur.

7. Dispositif de mémoire intégrée à semiconducteur suivant l'une des revendications 1 à 6, **caractérisé en ce que** la couche (22) diélectrique est un ferroélectrique ou un diélectrique à grand ε.

8. Dispositif de mémoire intégrée à semiconducteur suivant l'une des revendications 1 à 7, **caractérisé en ce que** la couche (23a) de platine est déposée par une opération de pulvérisation cathodique sur le corps semiconducteur.

9. Dispositif de mémoire intégrée à semiconducteur suivant l'une des revendications 1 à 8, **caractérisé en ce que** la couche (23b) en métal non précieux est déposée par une opération CVD sur le corps semiconducteur.
